# EUROPEAN PATENT APPLICATION

(11) **EP 3 509 098 A1**
(43) Date of publication of application: **10.07.2019**
(21) Application number: 18196815.7
(22) Date of filing: 26.09.2018
(51) Int. Cl.: H01L 23/29, H01L 23/31, H01L 25/065, H01L 23/485, H01L 23/48

(54) **SEMICONDUCTOR PACKAGE**

(30) Priority: 03.01.2018 KR 20180000532
(71) Applicant: Samsung Electronics Co., Ltd., Suwon-si, Gyeonggi-do 16677 (KR)
(72) Inventor: KIM, Young Lyong, Anyang-si, Gyeonggi-do 14055 (KR); BAEK, Seung Duk, Hwaseong-si, Gyeonggi-do 18482 (KR)
(74) Representative: Kuhnen & Wacker Patent- und Rechtsanwaltsbüro PartG mbB

(57) **Abstract**

A semiconductor package includes a first semiconductor chip having a first chip substrate, the first chip substrate having a first upper surface and a first lower surface opposite to each other, a first through-silicon via (TSV), a lower connection pad and a first lower passivation layer on the first lower surface of the first chip substrate, the first lower passivation layer exposing a portion of the lower connection pad, an upper connection pad and a first upper passivation layer on the first upper surface of the first chip substrate, the first upper passivation layer including a first upper inorganic material layer, and a second semiconductor chip connected to the first semiconductor chip, the second semiconductor chip including a second TSV, wherein the first lower passivation layer has a stacked structure of a first lower inorganic material layer and a lower organic material layer.

## Description

### CROSS-REFERENCE TO RELATED APPLICATION

Korean Patent Application No. 10-2018-0000532, filed on January 3, 2018, in the Korean Intellectual Property Office, and entitled: "Semiconductor Package," is incorporated by reference herein in its entirety.

### BACKGROUND

### 1. Field

The present disclosure relates to a semiconductor package, and more particularly, to a semiconductor package including a through-silicon via (TSV) structure.

### 2. Description of the Related Art

With the rapid development of the electronic industry and according to the needs of users, electronic devices are becoming smaller and lighter. Semiconductor packages used in electronic devices are required not only to be smaller and lighter but also to have high performance and large capacity. In order to realize high performance and large capacity together with miniaturization and weight reduction, a semiconductor chip including a through-silicon via (TSV) structure and a semiconductor package including the semiconductor chip are being continuously researched and developed.

### SUMMARY

According to embodiments, there is provided a semiconductor package including a first semiconductor chip having a first chip substrate, the first chip substrate having a first upper surface and a first lower surface opposite to each other, a first through-silicon via (TSV), a lower connection pad and a first lower passivation layer on the first lower surface of the first chip substrate, the first lower passivation layer exposing a portion of the lower connection pad, an upper connection pad and a first upper passivation layer on the first upper surface of the first chip substrate, the first upper passivation layer including a first upper inorganic material layer; and a second semiconductor chip connected to the first semiconductor chip, the second semiconductor chip including a second TSV, wherein the first lower passivation layer has a stacked structure of a first lower inorganic material layer and a lower organic material layer.

According to embodiments, there is also provided a semiconductor package including a first semiconductor chip having a first chip substrate including a first upper surface and a first lower surface opposite to each other, a first TSV, a first lower connection pad on the first lower surface of the first chip substrate, a first lower passivation layer including a pad trench exposing a portion of an upper surface of the first lower connection pad, the first lower passivation layer having a first lower inorganic material layer and a lower organic material layer on the first lower inorganic material layer, and a first upper passivation layer on the first upper surface of the first chip substrate, and a second semiconductor chip connected to the first semiconductor chip, the second semiconductor chip having a second chip substrate a second upper surface and a second lower surface opposite to each other, the second lower surface facing the first upper surface of the first chip substrate, a second TSV, a second lower connection pad, and a second lower passivation layer on the second lower surface of the second chip substrate, the second lower passivation layer including a second lower inorganic material layer.

According to embodiments, there is still provided a semiconductor package including a first semiconductor chip including a first chip substrate, a first TSV, and a first passivation layer, the first chip substrate including a first semiconductor device layer, and a second semiconductor chip connected to the first semiconductor chip, the second semiconductor chip including a second chip substrate, a second TSV, and a second passivation layer, and the second chip substrate including a second semiconductor device layer, wherein the first passivation layer includes an organic material layer, and the second passivation layer includes an inorganic material layer.

According to embodiments, there is yet provided a semiconductor package including a support substrate which includes a first surface and a second surface opposite to each other, and a stacked chip structure which is disposed on the first surface of the support substrate and connected to the support substrate, wherein the stacked chip structure includes a first semiconductor chip which includes a first chip substrate, a first TSV, a lower connection pad, an upper connection pad, a first lower passivation layer, and a first upper passivation layer, and a second semiconductor chip which is connected to the first semiconductor chip and includes a second TSV, wherein the first chip substrate includes a first lower surface facing the support substrate and a first upper surface opposite to the first lower surface, the lower connection pad and the first lower passivation layer are disposed on the first lower surface of the first chip substrate, the first lower passivation layer exposes a portion of the lower connection pad, the first upper passivation layer is disposed on the first upper surface of the first chip substrate, the upper connection pad is disposed on the first upper passivation layer, the second semiconductor chip is disposed on the first upper surface of the first chip substrate, the first upper passivation layer is made of a first upper inorganic material layer, and the first lower passivation layer includes a first lower inorganic material layer and a first lower organic material layer stacked sequentially on the first lower surface of the first chip substrate.

### BRIEF DESCRIPTION OF THE DRAWINGS

Features will become apparent to those of ordinary skill in the art by describing in detail exemplary embodiments with reference to the attached drawings, in which:
FIG. 1 illustrates a semiconductor package according to embodiments;
FIG. 2 illustrates an enlarged view of a portion P of FIG. 1;
FIG. 3 illustrates an enlarged view of a portion Q of FIG. 1;
FIG. 4 illustrates an enlarged view of a portion R of FIG. 1;
FIG. 5 illustrates a semiconductor package according to embodiments;
FIG. 6 illustrates a semiconductor package according to embodiments;
FIG. 7 illustrates a semiconductor package according to embodiments;
FIG. 8 illustrates a semiconductor package according to embodiments;
FIG. 9 illustrates a semiconductor package according to embodiments;
FIG. 10 illustrates an enlarged view of a portion S of FIG. 9;
FIG. 11 illustrates an enlarged view of a portion T of FIG. 9;
FIG. 12 illustrates a semiconductor package according to embodiments;
FIG. 13 illustrates a semiconductor package according to embodiments;
FIG. 14 illustrates a semiconductor package according to embodiments;
FIG. 15 illustrates a semiconductor package according to embodiments; and
FIGS. 16 through 25 illustrate views of stages in a method of manufacturing a semiconductor package according to embodiments.

### DETAILED DESCRIPTION

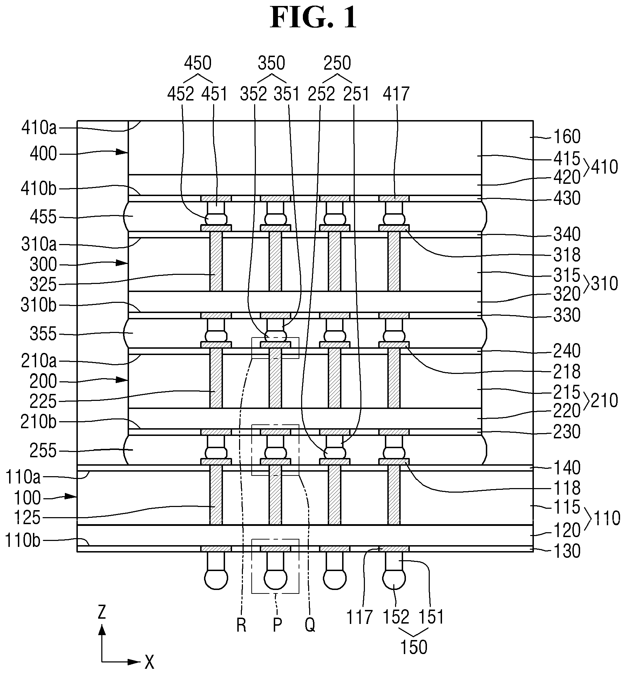

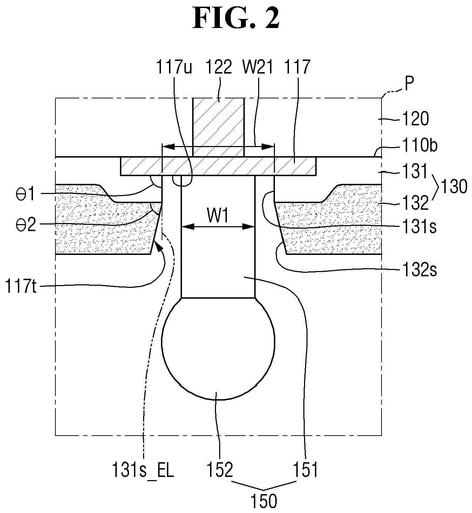

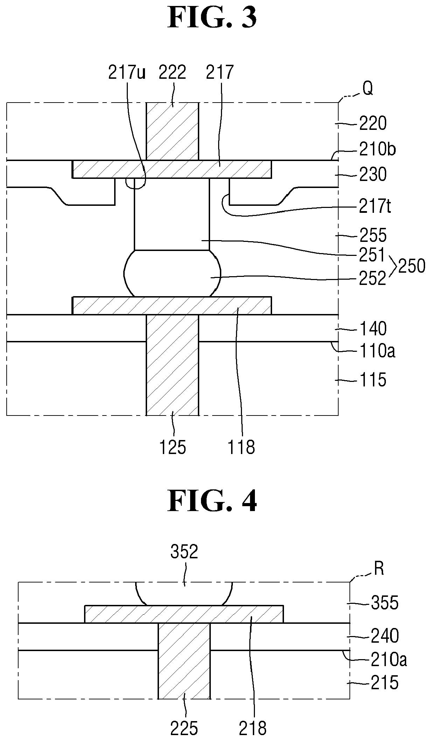

FIG. 1 illustrates a semiconductor package according to embodiments. FIG. 2 is an enlarged view of a portion P of FIG. 1. FIG. 3 is an enlarged view of a portion Q of FIG. 1. FIG. 4 is an enlarged view of a portion R of FIG. 1.

Referring to FIGS. 1 through 4, a semiconductor package according to embodiments may include a plurality of semiconductor chips stacked on top of each other. For example, as illustrated in FIG. 1, a semiconductor package may include a first semiconductor chip 100, a second semiconductor chip 200, a third semiconductor chip 300, and a fourth semiconductor chip 400 stacked sequentially in a vertical direction Z.

In an example, each of the first through fourth semiconductor chips 100 through 400 may be a memory semiconductor chip. The memory semiconductor chip may be a volatile memory semiconductor chip, e.g., a dynamic random access memory (DRAM) or a static random access memory (SRAM), or may be a nonvolatile memory semiconductor chip, e.g., a phase-change random access memory (PRAM), a magnetoresistive random access memory (MRAM), a ferroelectric random access memory (FeRAM) or a resistive random access memory (RRAM).

In another example, the first semiconductor chip 100 may be a logic semiconductor chip, and the second through fourth semiconductor chips 200 through 400 may be memory semiconductor chips. The first semiconductor chip 100 may be a controller semiconductor chip that controls the operation of the second through fourth semiconductor chips 200 through 400 electrically connected to the first semiconductor chip 100.

In FIG. 1, the semiconductor package includes a stack of four semiconductor chips. However, this is merely an example used for ease of description, and embodiments are not limited to this example.

The first semiconductor chip 100 may include a first chip substrate 110, first through-silicon vias (TSVs) 125, a first lower passivation layer 130, a first upper passivation layer 140, first lower connection pads 117, and first upper connection pads 118.

The first chip substrate 110 may include a lower surface 110b and an upper surface 110a which face each other. The first chip substrate 110 may include a first semiconductor substrate 115 and a first semiconductor device layer 120. The upper surface 110a of the first chip substrate 110 may be defined by the first semiconductor substrate 115, and the lower surface 110b of the first chip substrate 110 may be defined by the first semiconductor device layer 120.

The first semiconductor substrate 115 may be a bulk silicon substrate or a silicon-on-insulator (SOI) substrate. Otherwise, the first semiconductor substrate 115 may be a silicon substrate or a substrate made of another material, e.g., silicon germanium, silicon germanium on insulator (SGOI), indium antimonide, lead telluride, indium arsenide, indium phosphide, gallium arsenide or gallium antimonide.

The first semiconductor device layer 120 may include various types of individual devices and an interlayer insulating film. The individual devices may include a variety of microelectronic devices, e.g., metal-oxide-semiconductor field effect transistors (MOSFETs) (e.g., complementary metal-insulator-semiconductor (CMOS) transistors), system large-scale integration (LSI), flash memories, DRAMs, SRAMs, EEPROMs, PRAMs, MRAMs, RRAMs, image sensors (e.g., CMOS imaging sensors (CIS)), micro-electro-mechanical systems (MEMS), active devices, and passive devices. The individual devices may be electrically connected to a conductive area formed in the first semiconductor substrate 115. The first semiconductor device layer 120 may include a conductive wiring or a conductive plug for electrically connecting at least two of the individual devices or electrically connecting the individual devices to the conductive area of the first semiconductor substrate 115. In addition, the individual devices may be electrically insulated from neighboring individual devices by insulating layers, respectively.

The first TSVs 125 may be disposed within the first chip substrate 110. The first TSVs 125 may penetrate the first semiconductor substrate 115. A portion of each of the first TSVs 125 may protrude above the upper surface 110a of the first chip substrate 110.

In FIG. 1, the first TSVs 125 do not entirely penetrate the first chip substrate 110, e.g., the first TSVs 125 may penetrate the first semiconductor substrate 115 without penetrating the first semiconductor device layer 120. However, this is merely an example used for ease of description, and embodiments are not limited to this example.

The shape of the first TSVs 125 may vary depending on whether the first TSVs 125 are formed before a front end of line (FEOL) process, between the FEOL process and a back end of line (BEOL) process, during the BEOL process, or after the BEOL process.

The first lower connection pads 117 may be disposed on the lower surface 110b of the first chip substrate 110. The first lower connection pads 117 may be formed on the first semiconductor device layer 120. The first lower connection pads 117 and their connection will be described in more detail below with reference to FIG. 2.

The first lower connection pads 117 may respectively be electrically connected to first conductive wiring structures 122 formed in the first semiconductor device layer 120 (FIG. 2). The first lower connection pads 117 may be electrically connected to the first TSVs 125 by the first conductive wiring structures 122, respectively. The first lower connection pads 117 may include at least one of, e.g., aluminum (Al), copper (Cu), nickel (Ni), tungsten (W), platinum (Pt), and gold (Au).

The first lower passivation layer 130 may be disposed on the lower surface 110b of the first chip substrate 110. The first lower passivation layer 130 may be disposed on the first lower connection pads 117.

The first lower passivation layer 130 may expose a portion of each of the first lower connection pads 117. The first lower passivation layer 130 may cover at least a portion of each of the first lower connection pads 117. For example, as illustrated in FIG. 2, the first lower passivation layer 130 may expose a portion of a surface 117u of each of the first lower connection pads 117, while covering edges of the first lower connection pads 117.

The first lower passivation layer 130 may have a stacked structure of a first lower inorganic material layer 131 and a first lower organic material layer 132. The first lower inorganic material layer 131 may be disposed on the lower surface 110b of the first chip substrate 110. The first lower organic material layer 132 may be disposed on the first lower inorganic material layer 131, e.g., the first lower inorganic material layer 131 may be between the first lower organic material layer 132 and the lower surface 110b of the first chip substrate 110. For example, the first lower organic material layer 132 may cover, e.g., continuously, an entire surface of the first lower inorganic material layer 131 facing away from the first semiconductor device layer 120.

The first lower organic material layer 132 may be formed to protect the semiconductor package including the first through fourth semiconductor chips 100 through 400 from an external impact or the like. That is, when an external impact is applied to an exposed portion of the semiconductor package, the first lower organic material layer 132 may absorb or alleviate the external impact, thereby protecting the semiconductor package including the first lower inorganic material layer 131 and so on.

In addition, when the semiconductor package including the first through fourth semiconductor chips 100 through 400 is mounted on another support substrate (e.g., a semiconductor chip, an interposer, a printed circuit board (PCB)), the first lower organic material layer 132 may help an underfill material fill the space between the semiconductor package and the support substrate.

The first lower inorganic material layer 131 may be made of an inorganic insulating material. The first lower inorganic material layer 131 may include, but is not limited to, at least one of, e.g., silicon nitride, silicon oxide, and silicon oxynitride.

The first lower organic material layer 132 may be made of an organic insulating material. The first lower organic material layer 132 may include, but is not limited to, at least one of, e.g., epoxy, polyimide, benzocyclobutene (BCB), and polybenzoxazole (PBO).

The first lower passivation layer 130 may include first pad trenches 117t which partially expose the first lower connection pads 117, respectively. Each of the first pad trenches 117t may include sidewalls defined by the first lower passivation layer 130 and a bottom surface defined by the surface 117u of a corresponding first lower connection pad 117.

In the semiconductor package according to the embodiments, at least part of the sidewalls of each of the first pad trenches 117t may be defined by sidewalls 131s of the first lower inorganic material layer 131 and sidewalls 132s of the first lower organic material layer 132. For example, the sidewalls of each of the first pad trenches 117t may be defined by the sidewalls 131s of the first lower inorganic material layer 131 and the sidewalls 132s of the first lower organic material layer 132. The sidewalls 131s of the first lower inorganic material layer 131 and the sidewalls 132s of the first lower organic material layer 132 may be directly connected to each other.

In the semiconductor package according to the embodiments, the slope of the sidewalls 131s of the first lower inorganic material layer 131 may be different from that of the sidewalls 132s of the first lower organic material layer 132. An extension line 131s EL of each of the sidewalls 131s of the first lower inorganic material layer 131 which extends from a lowermost portion of a corresponding sidewall 131s of the first lower inorganic material layer 131 may not be parallel to the corresponding sidewall 132s of the first lower organic material layer 132. Here, the extension line 131s EL of each of the sidewalls 131s of the first lower inorganic material layer 131 may be a line formed by extending the sidewall 131s of the first lower inorganic material layer 131 from the boundary between the first lower inorganic material layer 131 and the first lower organic material layer 132. For example, the slope of the sidewalls 131s of the first lower inorganic material layer 131 may be larger than that of the sidewalls 132s of the first lower organic material layer 132.

Assuming that the boundary between the first lower organic material layer 132 and the first lower inorganic material layer 131 is parallel to the surface 117u of each of the first lower connection pads 117 in portions overlapping the first lower connection pads 117, an angle θ₁ formed by the sidewalls 131s of the first lower inorganic material layer 131 and the surface 117u of each of the first lower connection pads 117 may be larger than an angle θ₂ formed by the sidewalls 132s of the first lower organic material layer 132 and the surface 117u of each of the first lower connection pads 117.

Referring back to FIG. 1, the first upper passivation layer 140 may be disposed on the upper surface 110a of the first chip substrate 110. The first upper passivation layer 140 may be made of an inorganic material. That is, the first upper passivation layer 140 may be made of a first upper inorganic material layer. The first upper passivation layer 140 may include, but is not limited to, at least one of, e.g., silicon nitride, silicon oxide, and silicon oxynitride. In the semiconductor package according to the embodiments, the number of layers included in the first upper passivation layer 140 may be smaller than the number of layers included in the first lower passivation layer 130.

In the semiconductor package according to the embodiments, a first passivation layer (130 and 140) included in the first semiconductor chip 100 may include an organic material layer. The first lower passivation layer 130 includes an organic material layer. The first upper passivation layer 140 may not include an organic material layer and may be made of an inorganic material layer.

The first upper connection pads 118 may be disposed on the upper surface 110a of the first chip substrate 110. The first upper connection pads 118 may be disposed on the first upper passivation layer 140. The first upper connection pads 118 may be connected to the first TSVs 125, respectively. The first upper connection pads 118 may include at least one of, e.g., aluminum (Al), copper (Cu), nickel (Ni), tungsten (W), platinum (Pt), and gold (Au).

First connection bumps 150 may be disposed on the first lower connection pads 117, respectively. The first connection bumps 150, e.g., high bandwidth memory (HBM) bumps, may be connected to the first lower connection pads 117, respectively. The first connection bumps 150 may be disposed in the first pad trenches 117t, respectively.

Each of the first connection bumps 150 may include a first pillar structure 151 and a first solder layer 152. The first pillar structure 151 may be connected to each of the first lower connection pads 117. The first solder layer 152 may be disposed on the first pillar structure 151.

The first pillar structure 151 may include, e.g., nickel (Ni), a nickel alloy, copper (Cu), a copper alloy, palladium (Pd), platinum (Pt), gold (Au), cobalt, or a combination of these materials. The first solder layer 152 may have, e.g., a spherical or ball shape. The first solder layer 152 may include, e.g., tin (Sn), indium (In), bismuth (Bi), antimony (Sb), copper (Cu), silver (Ag), zinc (Zn), lead (Pb) and/or an alloy of these materials. For example, the first solder layer 152 may include Sn, Pb, Sn-Pb, Sn-Ag, Sn-Au, Sn-Cu, Sn-Bi, Sn-Zn, Sn-Ag-Cu, Sn-Ag-Bi, Sn-Ag-Zn, Sn-Cu-Bi, Sn-Cu-Zn, or Sn-Bi-Zn.

An intermediate layer may further be formed on a contact interface between the first solder layer 152 and the first pillar structure 151. The intermediate layer may include an intermetallic compound (IMC) formed when metal materials contained in the first solder layer 152 and the first pillar structure 151 react at a relatively high temperature. For example, when the first pillar structure 151 includes copper and/or nickel and the first solder layer 152 includes tin and/or copper, the intermediate layer may include at least one of (Cu, Ni)₆Sn₅, (Cu, Ni)₃Sn₄, and (Cu, Ni)₃Sn. However, the material or composition of the intermediate layer is not limited to the above example and may vary depending on the material of the first pillar structure 151, the material of the first solder layer 152, the temperature and time of a reflow process, and the like.

An under bump metal (UBM) layer may further be formed between the first pillar structure 151 and each of the first lower connection pads 117. The UBM layer may be a seed layer for forming the first pillar structure 151, an adhesive layer, or a barrier layer. For example, the UBM layer may include chromium (Cr), tungsten (W), titanium (Ti), copper (Cu), nickel (Ni), aluminum (Al), palladium (Pd), gold (Au), or a combination of these materials.

The UBM layer may be a single metal layer or may be a stacked structure of a plurality of metal layers. For example, the UBM layer may include a first metal layer, a second metal layer, and/or a third metal layer stacked sequentially on each of the first lower connection pads 117. The first metal layer may serve as an adhesive layer for stably attaching each first connection bump 150 formed on the first metal layer to a corresponding first lower connection pad 117 and/or the first lower passivation layer 130. For example, the first metal layer may include at least one of titanium (Ti), titanium-tungsten (Ti-W), chromium (Cr), and aluminum (Al). The second metal layer may serve as a barrier layer for preventing a metal material contained in each of the first lower connection pads 117 from diffusing into the first chip substrate 110. The second metal layer may include at least one of copper (Cu), nickel (Ni), chromium-copper (Cr-Cu), and nickel-vanadium (Ni-V). The third metal layer may serve as a seed layer for forming each of the first connection bumps 150 or as a wetting layer for improving wetting characteristics of solder layers. The third metal layer may include at least one of nickel (Ni), copper (Cu), and aluminum (Al).

Assuming that the first connection bumps 150 are in, e.g., direct, contact with the first lower connection pads 117, the first connection bumps 150 may not be in contact with the first lower passivation layer 130, e.g., the first pillar structure 151 may be spaced apart from the sidewalls 131s of the first lower passivation layer 130. In a plan view, the first pillar structure 151 may not include a portion overlapping the first lower passivation layer 130, i.e., in a vertical direction. In other words, referring to FIG. 2, a width W1 of the first pillar structure 151 is smaller than a width W21 of a lower part of each of the first pad trenches 117t, e.g., the first pillar structure 151 may be centered between and spaced apart from facing sidewalls 131s of the first lower passivation layer 130.

The second through fourth semiconductor chips 200 through 400 will now be described. For simplicity, a description of elements and features technically similar to those of the first semiconductor chip 100 will be given only briefly or omitted.

As illustrated in FIG. 1, the second semiconductor chip 200 may be disposed on the first semiconductor chip 100. The second semiconductor chip 200 may be disposed on the upper surface 110a of the first chip substrate 110. The second semiconductor chip 200 may be, e.g., electrically, connected to the first semiconductor chip 100.

The second semiconductor chip 200 may include a second chip substrate 210, second TSVs 225, a second lower passivation layer 230, a second upper passivation layer 240, second lower connection pads 217, and second upper connection pads 218.

The second chip substrate 210 may include a lower surface 210b and an upper surface 210a which face each other. The lower surface 210b of the second chip substrate 210 may face the upper surface 110a of the first chip substrate 110. The second chip substrate 210 may include a second semiconductor substrate 215 and a second semiconductor device layer 220. The upper surface 210a of the second chip substrate 210 may be defined by the second semiconductor substrate 215, and the lower surface 210b of the second chip substrate 210 may be defined by the second semiconductor device layer 220.

The second TSVs 225 may be disposed within the second chip substrate 210. The second TSVs 225 may penetrate the second semiconductor substrate 215. A portion of each of the second TSVs 225 may protrude above the upper surface 210a of the second chip substrate 210.

The second lower connection pads 217 may be disposed on the lower surface 210b of the second chip substrate 210. The second lower connection pads 217 may be formed on the second semiconductor device layer 220. The second lower connection pads 217 may respectively be electrically connected to second conductive wiring structures 222 formed in the second semiconductor device layer 220, as illustrated in FIG. 3.

The second lower passivation layer 230 may be disposed on the lower surface 210b of the second chip substrate 210. The second lower passivation layer 230 may be disposed on the second lower connection pads 217. The second lower passivation layer 230 may expose a portion of each of the second lower connection pads 217. For example, the second lower passivation layer 230 may expose a portion of a surface 217u of each of the second lower connection pads 217, while covering edges of the second lower connection pads 217. The second lower passivation layer 230 may include second pad trenches 217t which partially expose the second lower connection pads 217, respectively. The second lower passivation layer 230 may be made of an inorganic material. The second lower passivation layer 230 may be made of a second lower inorganic material layer.

The second upper passivation layer 240 may be disposed on the upper surface 210a of the second chip substrate 210. The second upper passivation layer 240 may be made of an inorganic material. That is, the second upper passivation layer 240 may be made of a second upper inorganic material layer.

In the semiconductor package according to the embodiments, a second passivation layer (230 and 240) included in the second semiconductor chip 200 may be made of inorganic material layers.

The second upper connection pads 218 may be disposed on the upper surface 210a of the second chip substrate 210. The second upper connection pads 218 may be disposed on the second upper passivation layer 240. The second upper connection pads 218 may be connected to the second TSVs 225, respectively.

Second connection bumps 250 may be disposed between the first semiconductor chip 100 and the second semiconductor chip 200. The second connection bumps 250 may, e.g., electrically, connect the first semiconductor chip 100 and the second semiconductor chip 200. Each of the second connection bumps 250 may include a second pillar structure 251 and a second solder layer 252. The second pillar structure 251 may be connected to each of the second lower connection pads 217. The second solder layer 252 may be disposed between the second pillar structure 251 and each of the first upper connection pads 118.

The third semiconductor chip 300 may be disposed on the second semiconductor chip 200. The third semiconductor chip 300 may be disposed on the upper surface 210a of the second chip substrate 210. The third semiconductor chip 300 may be connected to the second semiconductor chip 200. The second semiconductor chip 200 may be disposed between the first semiconductor chip 100 and the third semiconductor chip 300.

The third semiconductor chip 300 may include a third chip substrate 310, third TSVs 325, a third lower passivation layer 330, a third upper passivation layer 340, third lower connection pads 317, and third upper connection pads 318.

The third chip substrate 310 may include a lower surface 310b and an upper surface 310a which face each other. The lower surface 310b of the third chip substrate 310 may face the upper surface 210a of the second chip substrate 210. The third chip substrate 310 may include a third semiconductor substrate 315 and a third semiconductor device layer 320. The upper surface 310a of the third chip substrate 310 may be defined by the third semiconductor substrate 315, and the lower surface 310b of the third chip substrate 310 may be defined by the third semiconductor device layer 320.

The third TSVs 325 may be disposed within the third chip substrate 310. The third TSVs 325 may penetrate the third semiconductor substrate 315. A portion of each of the third TSVs 325 may protrude above the upper surface 310a of the third chip substrate 310.

The third lower connection pads 317 may be disposed on the lower surface 310b of the third chip substrate 310. The third lower connection pads 317 may be formed on the third semiconductor device layer 320. The third lower connection pads 317 may respectively be electrically connected to conductive wiring structures formed in the third semiconductor device layer 320.

The third lower passivation layer 330 may be disposed on the lower surface 310b of the third chip substrate 310. The third lower passivation layer 330 may be disposed on the third lower connection pads 317. The positional relationship between the third lower passivation layer 330 and the third lower connection pads 317 may be similar to the positional relationship between the second lower passivation layer 230 and the second lower connection pads 217 in FIG. 3. The third lower passivation layer 330 may be made of an inorganic material. The third lower passivation layer 330 may be made of a third lower inorganic material layer.

The third upper passivation layer 340 may be disposed on the upper surface 310a of the third chip substrate 310. The third upper passivation layer 340 may be made of an inorganic material. That is, the third upper passivation layer 340 may be made of a third upper inorganic material layer.

In the semiconductor package according to the embodiments, a third passivation layer (330 and 340) included in the third semiconductor chip 300 may be made of inorganic material layers.

The third upper connection pads 318 may be disposed on the upper surface 310a of the third chip substrate 310. The third upper connection pads 318 may be disposed on the third upper passivation layer 340. The third upper connection pads 318 may be connected to the third TSVs 325, respectively.

Third connection bumps 350 may be disposed between the second semiconductor chip 200 and the third semiconductor chip 300. The third connection bumps 350 may connect the second semiconductor chip 200 and the third semiconductor chip 300. Each of the third connection bumps 350 may include a third pillar structure 351 and a third solder layer 352.

In FIG. 1, the numbers of the first, second and third TSVs 125, 225 and 325 each are four. However, this is merely an example used for ease of description, and embodiments are not limited to this example.

The fourth semiconductor chip 400 may be disposed on the third semiconductor chip 300. The fourth semiconductor chip 400 may be connected to the third semiconductor chip 300. The third semiconductor chip 300 may be disposed between the second semiconductor chip 200 and the fourth semiconductor chip 400. The fourth semiconductor chip 400 may include a fourth chip substrate 410, a fourth lower passivation layer 430, and fourth lower connection pads 417.

The fourth chip substrate 410 may include a lower surface 410b and an upper surface 410a which face each other. The lower surface 410b of the fourth chip substrate 410 may face the upper surface 310a of the third chip substrate 310. The fourth chip substrate 410 may include a fourth semiconductor substrate 415 and a fourth semiconductor device layer 420. The upper surface 410a of the fourth chip substrate 410 may be defined by the fourth semiconductor substrate 415, and the lower surface 410b of the fourth chip substrate 410 may be defined by the fourth semiconductor device layer 420.

The fourth lower connection pads 417 may be disposed on the lower surface 410b of the fourth chip substrate 410. The fourth lower connection pads 417 may be formed on the fourth semiconductor device layer 420. The fourth lower connection pads 417 may respectively be electrically connected to conductive wiring structures formed in the fourth semiconductor device layer 420.

The fourth lower passivation layer 430 may be disposed on the lower surface 410b of the fourth chip substrate 410. The fourth lower passivation layer 430 may be disposed on the fourth lower connection pads 417. The positional relationship between the fourth lower passivation layer 430 and the fourth lower connection pads 417 may be similar to the positional relationship between the second lower passivation layer 230 and the second lower connection pads 217 in FIG. 3. The fourth lower passivation layer 430 may be made of an inorganic material. The fourth lower passivation layer 430 may be made of a fourth lower inorganic material layer.

Fourth connection bumps 450 may be disposed between the third semiconductor chip 300 and the fourth semiconductor chip 400. The fourth connection bumps 450 may connect the third semiconductor chip 300 and the fourth semiconductor chip 400. Each of the fourth connection bumps 450 may include a fourth pillar structure 451 and a fourth solder layer 452.

A first inter-chip molding material 255 may be disposed between the first semiconductor chip 100 and the second semiconductor chip 200. The first inter-chip molding material 255 may cover the second connection bumps 250. A second inter-chip molding material 355 may be disposed between the second semiconductor chip 200 and the third semiconductor chip 300. The second inter-chip molding material 355 may cover the third connection bumps 350. A third inter-chip molding material 455 may be disposed between the third semiconductor chip 300 and the fourth semiconductor chip 400. The third inter-chip molding material 455 may cover the fourth connection bumps 450. The first, second and third inter-chip molding materials 255, 355 and 455 may include an insulating material.

A package molding material 160 may be disposed on the first semiconductor chip 100. The package molding material 160 may be disposed on the first upper passivation layer 140. In the semiconductor package according to the embodiments, a width of the first semiconductor chip 100 in a horizontal direction X may be larger than a width of each of the second through fourth semiconductor chips 200 through 400 in the horizontal direction X. Thus, the package molding material 160 may be on the periphery of the first upper passivation layer 140 and can cover, e.g., continuously, respective sidewalls of the second through fourth semiconductor chips 200 through 400.

In FIG. 1, the package molding material 160 is not disposed on the upper surface 410a of the fourth chip substrate 410. However, embodiments are not limited to this case.

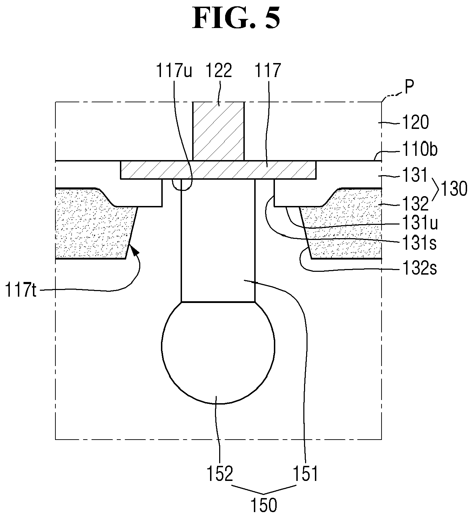

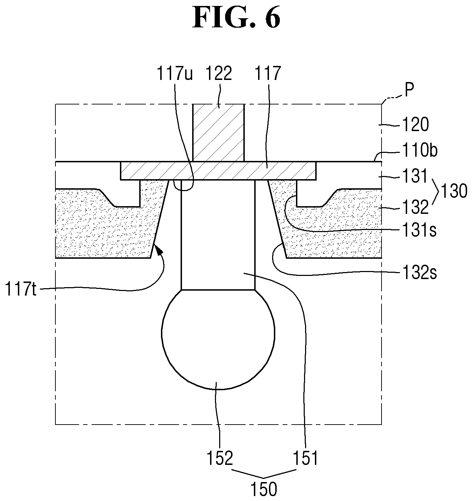

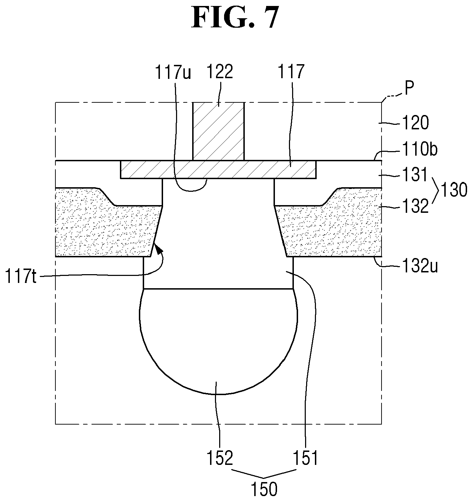

FIG. 5 illustrates a semiconductor package according to embodiments. FIG. 6 illustrates a semiconductor package according to embodiments. FIG. 7 illustrates a semiconductor package according to embodiments. For ease of description, the following embodiments will be described, focusing mainly on differences from the embodiments described above with reference to FIGS. 1 through 4. For reference, FIGS. 5 through 7 may be enlarged views of portion P of FIG. 1.

Referring to FIG. 5, in the semiconductor package according to the embodiments, sidewalls of a first pad trench 117t may have a stepped shape. That is, sidewalls 131s of the first lower inorganic material layer 131 and sidewalls 132s of the first lower organic material layer 132 may not be directly connected to each other, e.g., may be offset from each other in the horizontal direction X. The sidewalls of the first pad trench 117t may include the sidewalls 131s of the first lower inorganic material layer 131, the sidewalls 132s of the first lower organic material layer 132, and a surface 131u of the first lower inorganic material layer 131 which connects the sidewalls 131s of the first lower inorganic material layer 131 and the sidewalls 132s of the first lower organic material layer 132.

Referring to FIG. 6, in the semiconductor package according to the embodiments, sidewalls of a first pad trench 117t may be defined by sidewalls 132s of the first lower organic material layer 132. That is, the first lower organic material layer 132 may cover the entire sidewalls 131s of the first lower inorganic material layer 131.

Referring to FIG. 7, in the semiconductor package according to the embodiments, a width of a first pillar structure 151 in the horizontal direction X (see FIG. 1) is larger than a width of the first pad trench 117t in the horizontal direction X (see FIG. 1). Further, a portion of the first pillar structure 151 may extend along a surface 132u of a first lower organic material layer 132. In a plan view, the first pillar structure 151 includes a portion overlapping, e.g., an edge of, the surface 132u of the first lower organic material layer 132, e.g., in a vertical direction. For example, as shown in FIG. 7, the first pillar structure 151 may contact, e.g., directly contact, facing sidewalls of the first lower inorganic material layer 131 and of the first lower organic material layer 132, and a portion of the first pillar structure 151 may further extend along the horizontal direction X along the surface 132u of the first lower organic material layer 132 to partially overlap the surface 132u, e.g., so a width of the portion of the first pillar structure 151 that extends to overlap the surface 132u may have a total width larger than that of the first pad trench 117t.

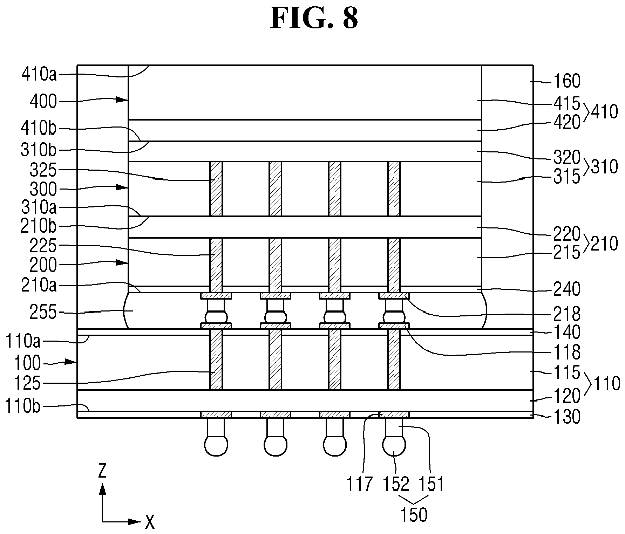

FIG. 8 illustrates a semiconductor package according to embodiments. For ease of description, the following embodiments will be described, focusing mainly on differences from the embodiments described above with reference to FIGS. 1 through 4.

Referring to FIG. 8, in the semiconductor package according to the embodiments, a second semiconductor chip 200 may be directly bonded to a third semiconductor chip 300, and the third semiconductor chip 300 may be directly bonded to a fourth semiconductor chip 400. That is, connection bumps, e.g., micro bumps or solder balls, may not be disposed between the second semiconductor chip 200 and the third semiconductor chip 300. In addition, connection bumps, e.g., micro bumps or solder balls, may not be disposed between the third semiconductor chip 300 and the fourth semiconductor chip 400.

In FIG. 8, second upper connection pads 218 are disposed on a second upper passivation layer 240. However, embodiments are not limited to this case. That is, the positional relationship between the second upper connection pads 218 and the second upper passivation layer 240 may be similar to the positional relationship between the second lower passivation layer 230 and the second lower connection pads 217 in FIG. 3.

FIG. 8 shows only an example in which the second through fourth semiconductor chips 200 through 400 are directly bonded to each other. However, embodiments are not limited to this example, and the second through fourth semiconductor chips 200 through 400 can be directly bonded to each other in various forms.

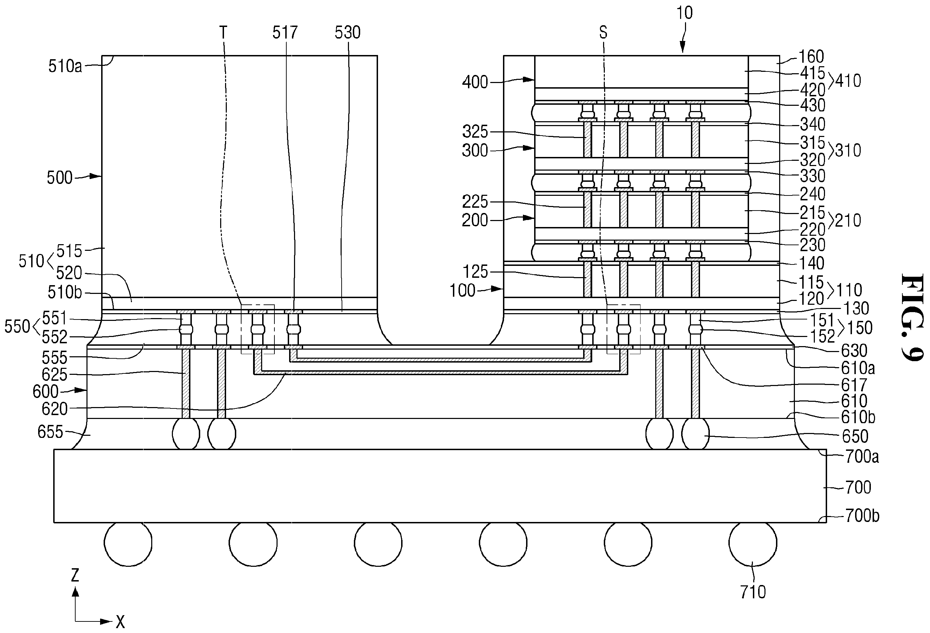

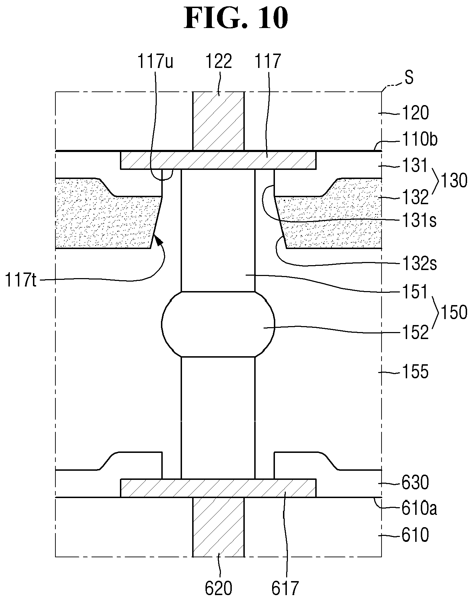

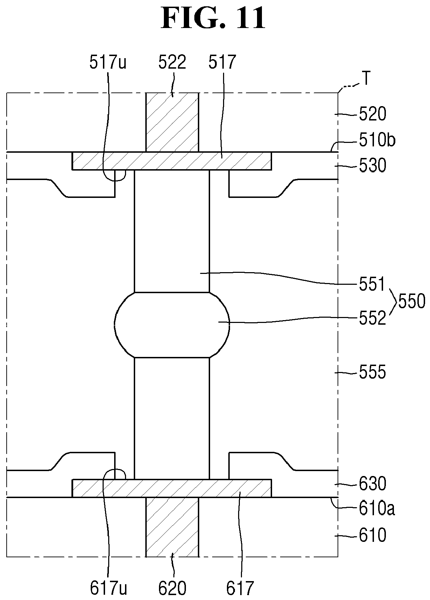

FIG. 9 illustrates a semiconductor package according to embodiments. FIG. 10 may be an enlarged view of a portion S of FIG. 9. FIG. 11 may be an enlarged view of a portion T of FIG. 9. For ease of description, the following embodiments will be described, focusing mainly on differences from the embodiments described above with reference to FIGS. 1 through 4.

Referring to FIGS. 9 through 11, the semiconductor package according to the embodiments may include a mounting substrate 700, an interposer substrate 600, a stacked chip structure 10, and a fifth semiconductor chip 500.

The stacked chip structure 10 may include the first through fourth semiconductor chips 100 through 400 sequentially stacked in the vertical direction Z. Since the first through fourth semiconductor chips 100 through 400 have been described above with reference to FIGS. 1 through 4, a description thereof is omitted.

The fifth semiconductor chip 500 may be, e.g., a processor unit. The fifth semiconductor chip 500 may be, but is not limited to, a microprocessor unit (MPU) or a graphic processor unit (GPU). In some embodiments, the fifth semiconductor chip 500 may be a package verified for normal operation, i.e., a known good package (KGP). The fifth semiconductor chip 500 may include a fifth chip substrate 510, a fifth lower passivation layer 530, and fifth lower connection pads 517.

The fifth chip substrate 510 may include a lower surface 510b and an upper surface 510a which face each other. The fifth chip substrate 510 may include a fifth semiconductor substrate 515 and a fifth semiconductor device layer 520. The upper surface 510a of the fifth chip substrate 510 may be defined by the fifth semiconductor substrate 515, and the lower surface 510b of the fifth chip substrate 510 may be defined by the fifth semiconductor device layer 520.

The fifth lower connection pads 517 may be disposed on the lower surface 510b of the fifth chip substrate 510. The fifth lower connection pads 517 may be formed on the fifth semiconductor device layer 520. The fifth lower connection pads 517 may respectively be electrically connected to third conductive wiring structures 522 formed in the fifth semiconductor device layer 520.

The fifth lower passivation layer 530 may be disposed on the lower surface 510b of the fifth chip substrate 510. The fifth lower passivation layer 530 may be disposed on the fifth lower connection pads 517. The fifth lower passivation layer 530 may expose a portion of each of the fifth lower connection pads 517. For example, the fifth lower passivation layer 530 may expose a portion of a surface 517u of each of the fifth lower connection pads 517.

The fifth lower passivation layer 530 may include at least one of an inorganic material and an organic material. In some embodiments, the fifth lower passivation layer 530 may be made of a fifth lower inorganic material layer.

The interposer substrate 600 may include a sixth chip substrate 610, inter-chip connection wirings 620, fifth TSVs 625, a fourth upper passivation layer 630, and fourth upper connection pads 617.

The sixth chip substrate 610 may include a lower surface 610b and an upper surface 610a which face each other. The sixth chip substrate 610 may include a semiconductor material. The inter-chip connection wirings 620 and the fifth TSVs 625 may be formed in the sixth chip substrate 610. In FIG. 9, the fifth TSVs 625 penetrate the sixth chip substrate 610. However, this is merely an example used for ease of description, and embodiments are not limited to this example.

The fourth upper connection pads 617 may be disposed on the upper surface 610a of the sixth chip substrate 610. The fourth upper connection pads 617 may be electrically connected to the inter-chip connection wirings 620 and the fifth TSVs 625, respectively.

The fourth upper passivation layer 630 may be disposed on the upper surface 610a of the sixth chip substrate 610. The fourth upper passivation layer 630 may be disposed on the fourth upper connection pads 617. The fourth upper passivation layer 630 may expose a portion of each of the fourth upper connection pads 617. For example, the fourth upper passivation layer 630 may expose a portion of an upper surface 617u of each of the fourth upper connection pads 617.

The fourth upper passivation layer 630 may include at least one of an inorganic material and an organic material. In some embodiments, the fourth upper passivation layer 630 may be made of a fourth upper inorganic material layer.

The interposer substrate 600 may include a first surface and a second surface which face each other. The first surface of the interposer substrate 600 may be located on the upper surface (610a) side of the sixth chip substrate 610, and the second surface of the interposer substrate 600 may be located on the lower surface (610b) side of the sixth chip substrate 610.

The stacked chip structure 10 and the fifth semiconductor chip 500 may be connected to the interposer substrate 600. The stacked chip structure 10 and the fifth semiconductor chip 500 may be disposed on the first surface of the interposer substrate 600. The stacked chip structure 10 and the fifth semiconductor chip 500 may be disposed on the upper surface 610a of the sixth chip substrate 610. A lower surface 110b (see FIG. 1) of a first chip substrate 110 of the stacked chip structure 10 faces the interposer substrate 600, and the lower surface 510b of the fifth chip substrate 510 faces the interposer substrate 600. The stacked chip structure 10 and the fifth semiconductor chip 500 located on the first surface of the interposer substrate 600 may be spaced apart from each other in the horizontal direction X.

On the upper surface 610a of the sixth chip substrate 610, each of the stacked chip structure 10 and the fifth semiconductor chip 500 may be electrically connected to the interposer substrate 600. The stacked chip structure 10 and the fifth semiconductor chip 500 may be connected to the fourth upper connection pads 617.

The stacked chip structure 10 may be electrically connected to the inter-chip connection wirings 620 and the fifth TSVs 625. The fifth semiconductor chip 500 may be electrically connected to the inter-chip connection wirings 620 and the fifth TSVs 625.

First connection bumps 150 may be disposed between the stacked chip structure 10 and the interposer substrate 600. The first connection bumps 150 may connect the stacked chip structure 10 and the interposer substrate 600. Although each of the first connection bumps 150 is illustrated as having a first solder layer 152 disposed between portions of a first pillar structure 151, embodiments are not limited to this case. That is, the first pillar structure 151 may not be present between the first solder layer 152 and each of the fourth upper connection pads 617.

Fifth connection bumps 550 may be disposed between the fifth semiconductor chip 500 and the interposer substrate 600. The fifth connection bumps 550 may connect the fifth semiconductor chip 500 and the interposer substrate 600. Each of the fifth connection bumps 550 may include a fifth pillar structure 551 and a fifth solder layer 552.

Although each of the fifth connection bumps 550 is illustrated as having the fifth solder layer 552 disposed between portions of the fifth pillar structure 551, embodiments are not limited to this case. That is, the fifth pillar structure 551 may not be present between the fifth solder layer 552 and each of the fourth upper connection pads 617.

The mounting substrate 700 may be a package substrate and may be, e.g., a PCB or a ceramic substrate. The mounting substrate 700 may include an upper surface and a lower surface 700a and 700b which face each other.

First connection terminals 710 may be disposed on the lower surface 700b of the mounting substrate 700. The first connection terminals 710 may electrically connect the semiconductor package to an external device. The first connection terminals 710 may provide electrical signals to the stacked chip structure 10 and the fifth semiconductor chip 500 or provide electrical signals from the stacked chip structure 10 and the fifth semiconductor chip 500 to an external device.

The interposer substrate 600 on which the stacked chip structure 10 and the fifth semiconductor chip 500 are mounted may be disposed on the upper surface 700a of the mounting substrate 700. The interposer substrate 600 may be connected to the mounting substrate 700.

Second connection terminals 650 may be disposed between the interposer substrate 600 and the mounting substrate 700. The second connection terminals 650 may electrically connect the interposer substrate 600 to the mounting substrate 700.

A fourth inter-chip molding material 155 may be disposed between the stacked chip structure 10 and the interposer substrate 600. The fourth inter-chip molding material 155 may cover the first connection bumps 150. A fifth inter-chip molding material 555 may be disposed between the fifth semiconductor chip 500 and the interposer substrate 600. The fifth inter-chip molding material 555 may cover the fifth connection bumps 550. A sixth inter-chip molding material 655 may be disposed between the interposer substrate 600 and the mounting substrate 700. The sixth inter-chip molding material 655 may cover the second connection terminals 650.

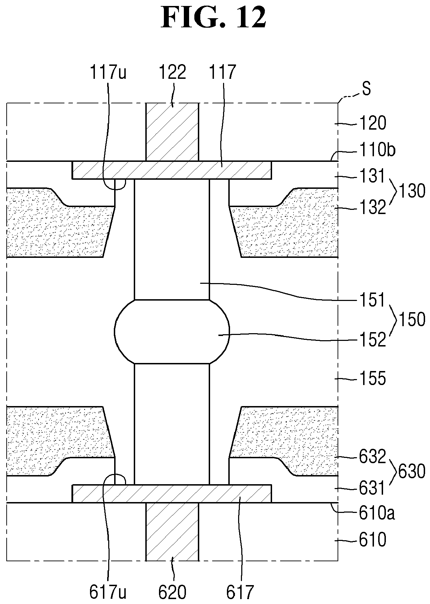

FIG. 12 illustrates a semiconductor package according to embodiments. For ease of description, the following embodiments will be described, focusing mainly on differences from the embodiments described above with reference to FIGS. 9 through 11. For reference, FIG. 12 may be an enlarged view of the portion S of FIG. 9.

Referring to FIG. 12, in the semiconductor package according to the embodiments, a fourth upper passivation layer 630 may have a stacked structure of a fourth upper inorganic material layer 631 and an upper organic material layer 632. That is, the fourth upper inorganic material layer 631 may be disposed on an upper surface 610a of a sixth chip substrate 610, and the upper organic material layer 632 may be disposed on the fourth upper inorganic material layer 631.

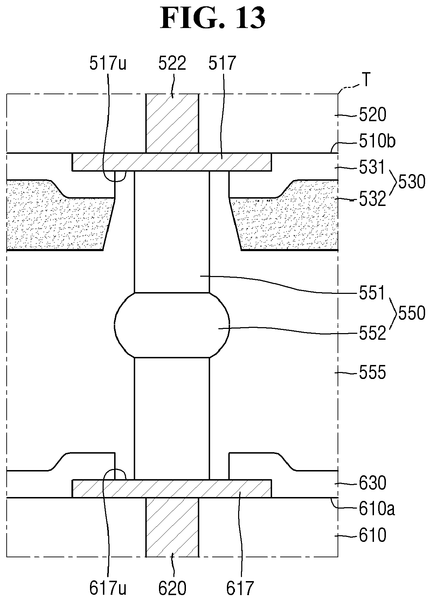

FIG. 13 illustrates a semiconductor package according to embodiments. For ease of description, the following embodiments will be described, focusing mainly on differences from the embodiments described above with reference to FIGS. 9 through 11. For reference, FIG. 13 may be an enlarged view of the portion T of FIG. 9.

Referring to FIG. 13, in the semiconductor package according to the embodiments, a fifth lower passivation layer 530 may have a stacked structure of a fifth lower inorganic material layer 531 and a second lower organic material layer 532. That is, the fifth lower inorganic material layer 531 may be disposed on a lower surface 510b of a fifth chip substrate, and the second lower organic material layer 532 may be disposed on the fifth lower inorganic material layer 531.

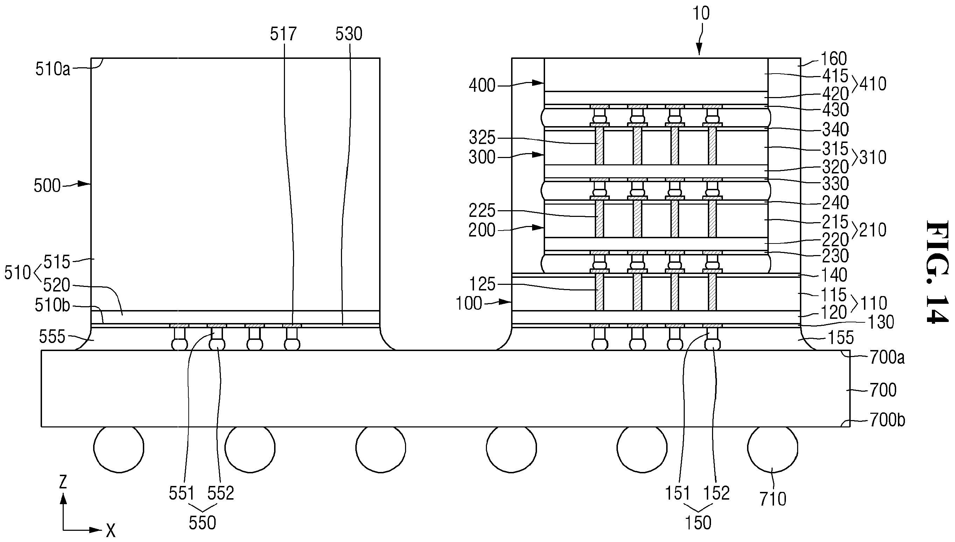

FIG. 14 illustrates a semiconductor package according to embodiments. For ease of description, the following embodiments will be described, focusing mainly on differences from the embodiments described above with reference to FIGS. 9 through 11.

Referring to FIG. 14, in the semiconductor package according to the embodiments, a stacked chip structure 10 and a fifth semiconductor chip 500 may be mounted on a mounting substrate 700 without an interposer substrate 600. Each of the stacked chip structure 10 and the fifth semiconductor chip 500 may be connected to an upper surface 700a of the mounting substrate 700.

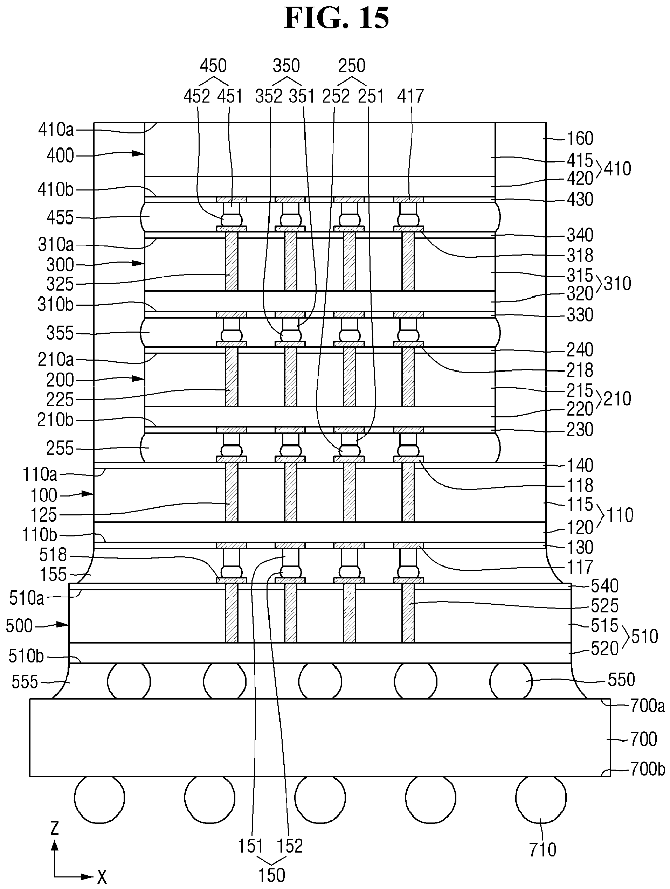

FIG. 15 illustrates a semiconductor package according to embodiments. For ease of description, the following embodiments will be described, focusing mainly on differences from the embodiments described above with reference to FIGS. 1 through 4.

Referring to FIG. 15, the semiconductor package according to the embodiments may further include a fifth semiconductor chip 500 and a mounting substrate 700.

The fifth semiconductor chip 500 may be, e.g., a processor unit. The fifth semiconductor chip 500 may be, but is not limited to, an MPU or a GPU. The fifth semiconductor chip 500 may include a fifth chip substrate 510, sixth TSVs 525, a fifth upper passivation layer 540, and fifth upper connection pads 518.

The fifth chip substrate 510 may include a lower surface 510b and an upper surface 510a which face each other. The fifth chip substrate 510 may include a fifth semiconductor substrate 515 and a fifth semiconductor device layer 520. The upper surface 510a of the fifth chip substrate 510 may be defined by the fifth semiconductor substrate 515, and the lower surface 510b of the fifth chip substrate 510 may be defined by the fifth semiconductor device layer 520.

The sixth TSVs 525 may be disposed within the fifth chip substrate 510. The sixth TSVs 525 may penetrate the fifth semiconductor substrate 515. A portion of each of the sixth TSVs 525 may protrude above the upper surface 510a of the fifth chip substrate 510.

The fifth upper passivation layer 540 may be disposed on the upper surface 510a of the fifth chip substrate 510. The fifth upper passivation layer 540 may include at least one of an inorganic material and an organic material.

The fifth upper connection pads 518 may be disposed on the upper surface 510a of the fifth chip substrate 510. The fifth upper connection pads 518 may be disposed on the fifth upper passivation layer 540. The fifth upper connection pads 518 may be connected to the sixth TSVs 525, respectively.

First through fourth semiconductor chips 100 through 400 may be disposed on the fifth semiconductor chip 500. The first through fourth semiconductor chips 100 through 400 may be disposed on the upper surface 510a of the fifth chip substrate 510.

The first semiconductor chip 100 may be connected to the fifth semiconductor chip 500. First connection bumps 150 may connect the first semiconductor chip 100 and the fifth semiconductor chip 500. A fourth inter-chip molding material 155 may be disposed between the first semiconductor chip 100 and the fifth semiconductor chip 500.

The first through fifth semiconductor chips 100 through 500 may be disposed on an upper surface of the mounting substrate 700. The fifth semiconductor chip 500 may be connected to the mounting substrate 700.

Fifth connection bumps 550 may be disposed between the fifth semiconductor chip 500 and the mounting substrate 700. The fifth connection bumps 550 may electrically connect the fifth semiconductor chip 500 to the mounting substrate 700. In FIG. 15, the fifth connection bumps 550 are shaped like solder balls. However, the shape of the fifth connection bumps 550 is not limited to the solder ball shape. A fifth inter-chip molding material 555 may be disposed between the fifth semiconductor chip 500 and the mounting substrate 700. The fifth inter-chip molding material 555 may cover the fifth connection bumps 550.

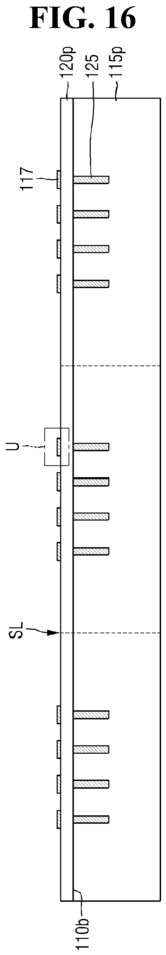

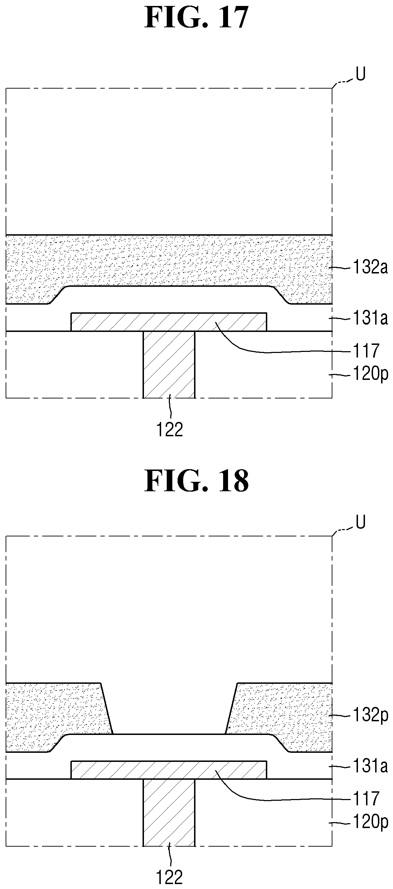

FIGS. 16 through 25 are views illustrating stages in a method of manufacturing a semiconductor package according to embodiments. FIGS. 16 through 25 may be a method of manufacturing the semiconductor package described above with reference to FIGS. 1 through 4. For reference, FIGS. 17 through 20 are enlarged views of a portion U of FIG. 16. FIGS. 17 through 20 are views illustrating a process of forming the first lower passivation layer 130 (see FIG. 1).

Referring to FIG. 16, the first TSVs 125 may be formed in a semiconductor wafer 115p. A pre-semiconductor device layer 120p may be formed on the lower surface 110b of the semiconductor wafer 115p.

First lower connection pads 117 may be formed on the pre-semiconductor device layer 120p. When the semiconductor wafer 115p, the pre-semiconductor device layer 120p, and the first lower connection pads 117 are separated by scribe lanes SL, a plurality of the first semiconductor chips 100 (see FIG. 1) can be made.

Referring to FIG. 17, a pre-lower inorganic material layer 131a may be formed on the first lower connection pads 117, e.g., the pre-lower inorganic material layer 131a may be formed on the entire pre-semiconductor device layer 120p to conformally cover the first lower connection pads 117. Next, a pre-lower organic material layer 132a may be formed on the, e.g., entire, pre-lower inorganic material layer 131a.

Referring to FIG. 18, the pre-lower organic material layer 132a may be partially removed to form a patterned lower organic material layer 132p on the pre-lower inorganic material layer 131a. The patterned lower organic material layer 132p may partially expose the pre-lower inorganic material layer 131a formed on an upper surface of each of the first lower connection pads 117.

In an example, the pre-lower organic material layer 132a may be an organic material that is sensitive to light. In this case, the patterned lower organic material layer 132p may be formed without a process of forming a mask pattern on the pre-lower organic material layer 132a.

In another example, the pre-lower organic material layer 132a may be partially removed using a mask pattern formed on the pre-lower organic material layer 132a. Accordingly, the patterned lower organic material layer 132p may be formed.

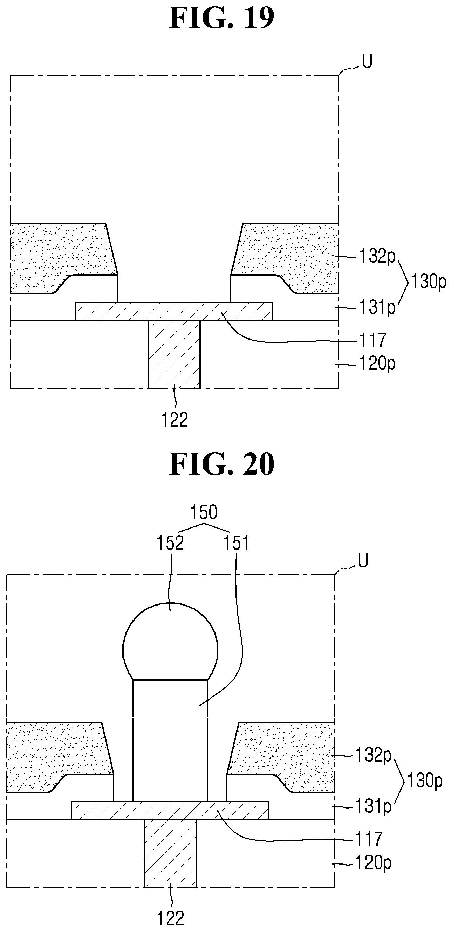

Referring to FIG. 19, the pre-lower inorganic material layer 131a may be partially removed using the patterned lower organic material layer 132p. Accordingly, a patterned lower inorganic material layer 131p may be formed to partially expose each of the first lower connection pads 117. A pre-lower passivation layer 130p may be formed to partially expose each of the first lower connection pads 117. The pre-lower passivation layer 130p includes the patterned lower inorganic material layer 131p and the patterned lower organic material layer 132p.

Referring to FIG. 20, the first connection bump 150 may be formed on each of the exposed first lower connection pads 117. The first connection bump 150 may include the first pillar structure 151 and the first solder layer 152.

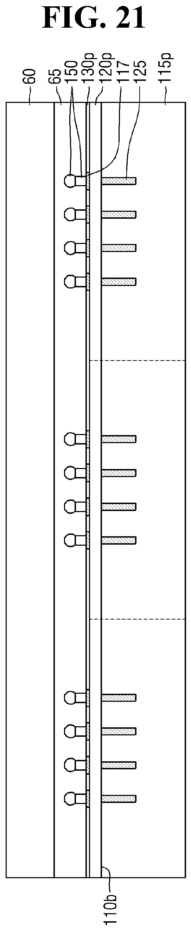

Referring to FIG. 21, the semiconductor wafer 115p having the first connection bumps 150 may be attached to a carrier substrate 60. An adhesive material layer 65 may be disposed between the carrier substrate 60 and the semiconductor wafer 115p. The adhesive material layer 65 may cover the first connection bumps 150.

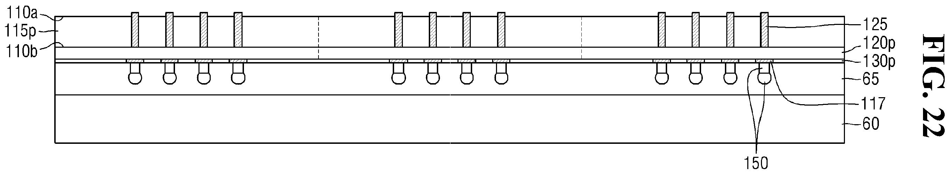

Referring to FIG. 22, the semiconductor wafer 115p may be partially removed to expose the first TSVs 125, e.g., a bottom of the semiconductor wafer 115p may be partially removed to expose the first TSVs 125 (FIG. 22 illustrates the structure of FIG. 21 in a flipped form). After removal of a portion of the semiconductor wafer 115p, a portion of each of the first TSVs 125 may protrude above the upper surface 110a of the semiconductor wafer 115p.

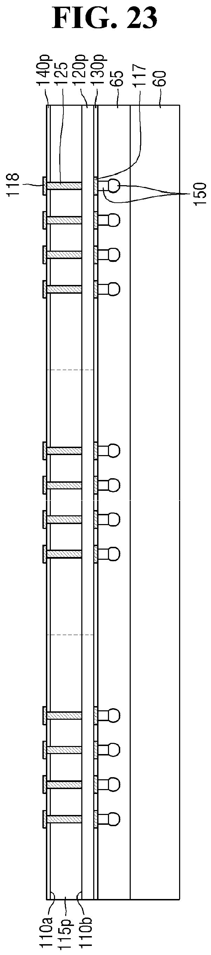

Referring to FIG. 23, a pre-upper passivation layer 140p may be formed on the upper surface 110a of the semiconductor wafer 115p. The pre-upper passivation layer 140p does not cover upper surfaces of the first TSVs 125. That is, the upper surfaces of the first TSVs 125 are exposed through the pre-upper passivation layer 140p. Next, the first upper connection pads 118 may be formed on the exposed upper surfaces of the first TSVs 125.

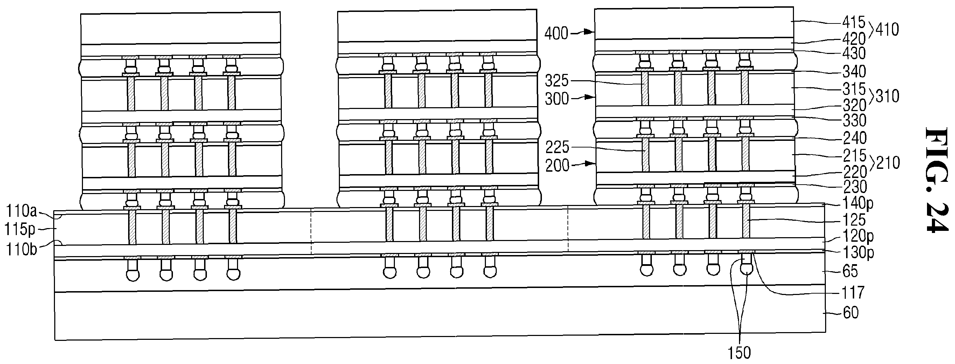

Referring to FIG. 24, second semiconductor chips 200 may be mounted on the first upper connection pads 118. The second semiconductor chips 200 may be connected to the first upper connection pads 118. Then, third semiconductor chips 300 and fourth semiconductor chips 400 may be sequentially mounted on the second semiconductor chips 200, respectively.

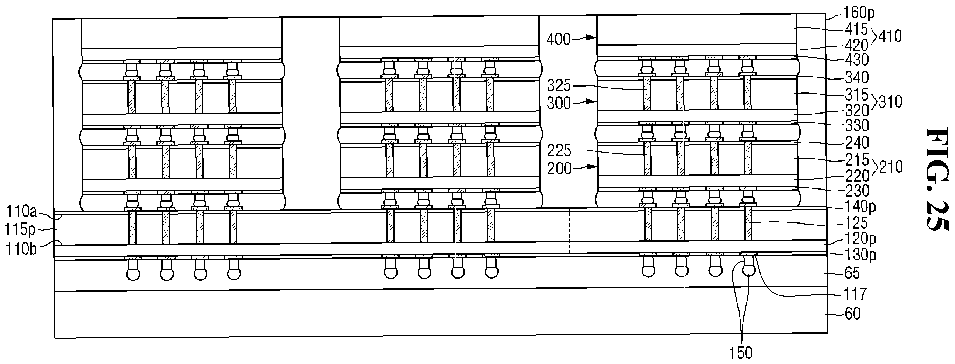

Referring to FIG. 25, a pre-package molding material 160p covering sidewalls of the second through fourth semiconductor chips 200 through 400 may be formed on the upper surface 110a of the semiconductor wafer 115p. Although the pre-package molding material 160p is illustrated as not covering upper surfaces of the fourth semiconductor chips 400, embodiments are not limited to this case.

Next, the carrier substrate 60 and the adhesive material layer 65 may be removed. In addition, the semiconductor wafer 115p may be cut along the scribe lanes SL (see FIG. 16). Accordingly, the second through fourth semiconductor chips 200 through 400 sequentially stacked on the first semiconductor chips 100 may be formed.

By way of summation and review, aspects of embodiments provide a semiconductor package capable of realizing high performance and large capacity together with miniaturization and weight reduction. Aspects of embodiments also provide a method of manufacturing a semiconductor package capable of realizing high performance and large capacity together with miniaturization and weight reduction.

That is, according to embodiments, a semiconductor package includes a plurality of semiconductor chips on top of each other and connected to each other via connection bumps on connection pads. A passivation layer exposing the connection bumps and portions of corresponding connection pads has a stacked structure of an inorganic material layer and an organic material layer, e.g., a polymer, so the organic material layer protects the inorganic material layer from damage, e.g., particle damage.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the spirit and scope of the present invention as set forth in the following claims.

## Claims

1. A semiconductor package, comprising:
a first semiconductor chip including:
a first chip substrate, the first chip substrate having a first upper surface and a first lower surface opposite to each other,
a first through-silicon via (TSV),
a lower connection pad and a first lower passivation layer on the first lower surface of the first chip substrate, the first lower passivation layer exposing a portion of the lower connection pad,
an upper connection pad and a first upper passivation layer on the first upper surface of the first chip substrate, the first upper passivation layer including a first upper inorganic material layer; and
a second semiconductor chip connected to the first semiconductor chip, the second semiconductor chip including a second TSV,
wherein the first lower passivation layer has a stacked structure of a first lower inorganic material layer and a lower organic material layer.

2. The semiconductor package as claimed in claim 1, wherein the first lower inorganic material layer is on the first lower surface of the first chip substrate, and the lower organic material layer is on the first lower inorganic material layer.

3. The semiconductor package as claimed in claim 1, wherein the second semiconductor chip is on the first upper surface of the first chip substrate.

4. The semiconductor package as claimed in claim 1, wherein:
the second semiconductor chip includes a second chip substrate having a second upper surface and a second lower surface opposite to each other, a second upper passivation layer on the second upper surface of the second chip substrate, and a second lower passivation layer on the second lower surface of the second chip substrate, and
each of the second upper passivation layer and the second lower passivation layer includes an inorganic material layer.

5. The semiconductor package as claimed in claim 4, wherein the second semiconductor chip is on the first upper surface of the first chip substrate.

6. The semiconductor package as claimed in claim 1, further comprising a third semiconductor chip connected to the second semiconductor chip, the second semiconductor chip being between the first semiconductor chip and the third semiconductor chip.

7. The semiconductor package as claimed in claim 6, further comprising a connection bump between the second semiconductor chip and the third semiconductor chip.

8. The semiconductor package as claimed in claim 1, wherein the first chip substrate includes a first semiconductor device layer, and the second semiconductor chip includes a second semiconductor device layer.

9. A semiconductor package, comprising:
a first semiconductor chip including:
a first chip substrate including a first upper surface and a first lower surface opposite to each other,
a first TSV,
a first lower connection pad on the first lower surface of the first chip substrate,
a first lower passivation layer including a pad trench exposing a portion of an upper surface of the first lower connection pad, the first lower passivation layer having a first lower inorganic material layer and a lower organic material layer on the first lower inorganic material layer, and
a first upper passivation layer on the first upper surface of the first chip substrate; and
a second semiconductor chip connected to the first semiconductor chip, the second semiconductor chip including:
a second chip substrate a second upper surface and a second lower surface opposite to each other, the second lower surface facing the first upper surface of the first chip substrate,
a second TSV,
a second lower connection pad, and
a second lower passivation layer on the second lower surface of the second chip substrate, the second lower passivation layer including a second lower inorganic material layer.

10. The semiconductor package as claimed in claim 9, wherein the first upper passivation layer includes a first upper inorganic material layer.

11. The semiconductor package as claimed in claim 9, wherein:
the second semiconductor chip further includes a second upper passivation layer on the second upper surface of the second chip substrate, and
the second upper passivation layer includes a second upper inorganic material layer.

12. The semiconductor package as claimed in claim 9, wherein at least part of sidewalls of the pad trench are defined by sidewalls of the first lower inorganic material layer and sidewalls of the lower organic material layer.

13. The semiconductor package as claimed in claim 9, further comprising a connection bump connected to each of the first lower connection pad and the second lower connection pad, the connection bump including a pillar structure and a solder layer, and a width of the pillar structure being smaller than a width of the pad trench.

14. A semiconductor package, comprising:
a first semiconductor chip including a first chip substrate, a first TSV, and a first passivation layer, the first chip substrate including a first semiconductor device layer; and
a second semiconductor chip connected to the first semiconductor chip, the second semiconductor chip including a second chip substrate, a second TSV, and a second passivation layer, and the second chip substrate including a second semiconductor device layer,
wherein the first passivation layer includes an organic material layer, and the second passivation layer includes an inorganic material layer.

15. The semiconductor package as claimed in claim 14, wherein:
the first chip substrate includes a first upper surface and a first lower surface opposite to each other,
the first passivation layer includes a first upper passivation layer on the first upper surface of the first chip substrate and a first lower passivation layer on the first lower surface of the first chip substrate,
the first lower passivation layer includes the organic material layer, and
the first upper passivation layer does not include the organic material layer.
